# EUROPÄISCHE PATENTSCHRIFT

(11) **EP 1 866 236 B1**
(45) Veröffentlichungstag und Bekanntmachung des Hinweises auf die Patenterteilung: **08.03.2017**
(21) Anmeldenummer: 06723981.4
(22) Anmeldetag: 03.04.2006
(51) Int. Cl.: B81C 1/00

(54) **MIKROMECHANISCHES BAUTEIL SOWIE VERFAHREN ZUR HERSTELLUNG EINES MIKROMECHANISCHEN BAUTEILS**
MICROMECHANICAL COMPONENT AND METHOD FOR FABRICATING A MICROMECHANICAL COMPONENT
COMPOSANT MICROMECANIQUE, ET SON PROCEDE DE PRODUCTION

(30) Priorität: 05.04.2005 DE 102005015584
(43) Veröffentlichungstag der Anmeldung: 19.12.2007
(73) Patentinhaber: Northrop Grumman LITEF GmbH, 79115 Freiburg (DE)
(72) Erfinder: GEIGER, Wolfram, 79115 Freiburg (DE); BRENG, Uwe, 79194 Gundelfingen (DE)
(74) Vertreter: Müller Hoffmann & Partner
(86) Internationale Anmeldenummer: PCT/EP2006/003023
(87) Internationale Veröffentlichungsnummer: WO 2006/105924

(56) Entgegenhaltungen:
- EP-A- 1 203 748
- EP-A1- 1 014 094
- WO-A-98/53483
- FR-A- 2 687 778
- JP-A- H07 263 709
- JP-A- 2001 141 463
- JP-A- 2003 329 704
- US-B1- 6 225 145
- HENMI H ET AL: "VACUUM PACKAGING FOR MICROSENSORS BY GLASS-SILICON ANODIC BONDING" SENSORS AND ACTUATORS A, ELSEVIER SEQUOIA S.A., LAUSANNE, CH, Bd. A43, Nr. 1/3, 1. Mai 1994 (1994-05-01), Seiten 243-248, XP000454118 ISSN: 0924-4247

## Beschreibung

Die Erfindung betrifft ein Bauteil, insbesondere ein mikromechanisches, mikro-elektromechanisches oder mikro-opto-elektromechanisches Bauteil sowie ein Verfahren zum Herstellen eines derartigen Bauteils.

Um Umwelteinflüsse wie Feuchtigkeit oder Verunreinigungen (z. B. Staub) auf mikro-elektromechanische Bauteile (MEMS) bzw. mikro-opto-elektromechanische Bauelemente (MOEMS) möglichst gering zu halten, werden die aktiven Strukturen derartiger Bauteile (unter "aktiver Struktur" sind hier insbesondere bewegliche Strukturen, optische Strukturen oder Strukturen, die gleichermaßen bewegliche und optische Komponenten aufweisen (z. B. bewegliche Spiegel) zu verstehen. Der Begriff "aktives Gebiet" bezeichnet das Gebiet bzw. Volumen des Bauteils, in dem die aktive Struktur liegt bzw. sich bewegt) häufig hermetisch dicht verkapselt. Die hermetisch dichte Verkapselung kann weiterhin zur Einstellung eines bestimmten Innendrucks im Bereich der aktiven Strukturen genutzt werden, was insbesondere bei Bauteilen, deren Funktionsweise von einem definierten Innendruck abhängt, wie z.B. Beschleunigungssensoren und Gyroskopen (Drehraten-Sensoren) vorteilhaft ist.

Damit möglichst kostengünstig produziert werden kann, erfolgt die Fertigung von MEMS- bzw. MOEMS-Bauteilen in der Regel auf Wafer-Ebene. Die dabei häufig durchzuführenden Fügeprozesse können beispielsweise auf Basis von Direktbondprozessen sowie anodischen Bondprozessen erfolgen.

Die Herausführung elektrischer Kontakte aus dem hermetisch dichten Bereich des Bauteils zur Kontaktierung von bestimmten Teilen des Bauteils (z. B. zur Kontaktierung der aktiven Struktur) ist fertigungstechnisch schwierig zu realisieren. Es kommen mehrerlei Möglichkeiten in Betracht: Die elektrischen Kontakte können beispielsweise durch lateral verlaufende, mittels Implantations- bzw. Diffusionsverfahren hergestellte Halbleiterschichten mit niedrigem Schichtwiderstand realisiert werden (Referenz 1). Weiterhin ist eine Realisierung durch strukturierte, mit einer planarisierten Passivierungsschicht bedeckte leitfähige Schichten möglich.

Alternativ können die elektrischen Kontakte in Form mehrerer vertikal verlaufender Durchkontaktierungen aus dem Bauteil herausgeführt werden. Zur Erzeugung vertikaler Durchkontaktierungen werden zunächst Kontaktlöcher in dem Bauteil erzeugt, in die anschließend leitfähiges Material eingebracht wird.

Das leitfähige Material, das in die Kontaktlöcher eingebracht wird, kann beispielsweise Metall sein, das durch einen Bedampfungsprozess, einen Sputterprozess, einen Galvanikprozess bzw. einen CVD-(Chemical Vapor Deposition)-Prozesses abgeschieden wird. Das leitende Material kann auch aus einem anderen Material, beispielsweise einem dotierten Halbleiter (Polysilizium) bestehen. Vor Einbringen des leitfähigen Materials in die Kontaktlöcher werden in der Regel die Innenwände der Kontaktlöcher mit einem isolierenden Material, beispielsweise SiO₂, Si₃N₄, Polyimid oder ähnlichem versehen, um elektrische Kurzschlüsse des leitenden Materials mit anderen leitfähigen Bereichen des Bauteils zu vermeiden.

Die Kontaktlöcher können auf unterschiedliche Art und Weise erzeugt werden: So werden üblicherweise auf Ultraschall-(Referenz 2, 3), Sandstrahl-(Referenz 2) oder Wasserstrahl-basierende Bohrverfahren eingesetzt. Die durch diese Bohrverfahren erzeugten Kontaktlöcher weisen Kontaktlochdurchmesser von mehreren 100 *µ*m auf und eignen sich deshalb zur Herstellung von MEMS- bzw. MOEMS-Bauelementen mit geringen Abmessungen nur bedingt. Nachteilig an diesen Bohrverfahren ist weiterhin, dass sie erforderlichen Reinraumkriterien nur teilweise gerecht werden. Um diesen Nachteil zu vermeiden, ist es bekannt, die Kontaktlöcher durch einen Laserstrahl-Bohrprozess herzustellen. Dieses Bohrverfahren vermeidet zwar die oben genannten Nachteile, führt jedoch aufgrund der beim Bohren auftretenden hohen Temperaturen häufig zu Materialspannungen bzw. Aufschmelzungen, was Probleme bei der weiteren Bearbeitung des Bauelements bereitet. Aus diesem Grund ist man dazu übergegangen, Kontaktlöcher durch chemisches bzw. plasmachemisches Strukturieren zu realisieren.

Die Druckschriften WO98/53483, JP 2003 329704 A, JP 2001 141463 A, JP H07 263709 A,

EP 1 014 094 A1, US 6 225 145 B1 offenbaren jeweils ein Verfahren zum Herstellen eines mikromechanischen Bauteils umfassend ein erstes und ein zweites Substrat und eine eine aktive Struktur umfassende Strukturschicht, wobei die aktive Struktur in einem hermetisch dichten Bereich zwischen dem ersten und dem zweiten Substrat angeordnet ist. Die Druckschriften beschäftigen sich jeweils mit der elektrischen Kontaktierung der aktiven Struktur.

Die der Erfindung zugrunde liegende Aufgabe ist, ein fertigungstechnisch einfach zu realisierendes Verfahren zum Herstellen eines Bauteils, insbesondere eines mikro-elektromechanischen oder mikro-opto-elektromechanischen Bauteils anzugeben, das eine zuverlässige, hermetisch dichte Verkapselung entsprechender aktiver Strukturen sowie das hermetisch dichte Herausführen der elektrischen Kontakte zur Kontaktierung der aktiven Strukturen aus dem Bauteil ermöglicht.

Zur Lösung dieser Aufgabe stellt die Erfindung Herstellungsverfahren gemäß den unabhängigen Patentansprüchen bereit. Vorteilhafte Ausgestaltungen bzw. Weiterbildungen des Erfindungsgedankens finden sich in den Unteransprüchen.

Das erfindungsgemäße Verfahren zum Herstellen insbesondere eines mikromechanischen, mikro-elektromechanischen bzw. mikro-opto-elektromechanischen Bauteils weist die folgenden Schritte auf:
- Erzeugen eines ersten Schichtverbunds, der ein erstes Substrat und eine erste Isolationsschicht, die wenigstens einen Teil der Oberfläche des ersten Substrats bedeckt, aufweist,
- Erzeugen eines zweiten Schichtverbunds, der ein zweites Substrat und eine zweite Isolationsschicht, die wenigstens einen Teil der Oberfläche des zweiten Substrats bedeckt, aufweist,
- Aufbringen einer zumindest teilweise leitfähigen Strukturschicht auf die erste Isolationsschicht,
- Aufbringen des zweiten Verbunds auf die Strukturschicht, derart, dass die zweite Isolationsschicht an die Strukturschicht angrenzt,
- wobei der erste und zweite Schichtverbund sowie die Strukturschicht so strukturiert sind, dass zumindest ein Teil der Strukturschicht, der das aktive Gebiet des Bauteils beinhaltet, durch den ersten und zweiten Schichtverbund hermetisch dicht verschlossen wird, und
- Ausbilden von Kontaktlöchern zur Kontaktierung leitfähiger Bereiche der Strukturschicht, die innerhalb des ersten und/oder zweiten Substrats ausgebildet sind und bis zu den leitfähigen Bereichen der Strukturschicht reichen.

Ein wesentlicher Aspekt der Erfindung ist, dass das aktive Gebiet und damit die aktive Struktur des herzustellenden Bauteils von der Umwelt des Bauteils isoliert wird (was Verunreinigungen und Feuchtigkeit anbelangt), bevor die Erzeugung der Kontaktlöcher erfolgt. Dies hat den Vorteil, dass beim Zusammenfügen des ersten und zweiten Schichtverbunds sowie der Strukturschicht zu einem Gesamtschichtverbund (Fügeprozess) hohe Temperaturen (> 400°C) zum Einsatz kommen können, da die Gefahr des unbeabsichtigten Lösens (Festkörperlöslichkeit), Legierens bzw. Schmelzens bereits ausgebildeter Kontaktierungen (Metallisierungen), ausgeschlossen werden kann.

Elektrische Ströme, die die aktive Struktur zum Betrieb des Bauteils benötigt bzw. Signale, die durch die aktive Struktur erzeugt werden, werden über die Kontaktlöcher und über die sich daran anschließende leitfähige Strukturschicht der aktiven Struktur zugeführt bzw. von dieser abgegriffen.

In einer bevorzugten Ausführungsform wird die aktive Struktur des erfindungsgemäß hergestellten Bauteils durch Strukturieren der Strukturschicht erzeugt, wobei das Strukturieren vor oder nach Aufbringen der Strukturschicht auf den ersten Schichtverbund erfolgen kann. Die Strukturierung kann beispielsweise durch Aufbringen einer Maske auf der Oberfläche der Strukturschicht und anschließendem Ätzen der Strukturschicht erfolgen. Wenn die Strukturschicht erst nach dem Aufbringen auf den ersten Schichtverbund strukturiert wird, so müssen beim Aufbringen der Strukturschicht auf den ersten Schichtverbund keine Fügetoleranzen berücksichtigt werden.

In der folgenden Beschreibung sei beispielhaft davon ausgegangen, dass die Kontaktlöcher innerhalb des ersten Substrats ausgebildet werden.

Vorzugsweise werden in der der Strukturschicht zugewandten Seite des ersten Substrats vor Aufbringen der Strukturschicht auf den ersten Schichtverbund erste Vertiefungen erzeugt, deren laterale Positionen wenigstens teilweise den lateralen Positionen der Kontaktlöcher entsprechen, die später im ersten Substrat ausgebildet werden. Die ersten Vertiefungen können in einem späteren Prozessstadium des erfindungsgemäßen Herstellungsverfahrens als Kontaktlöcher (oder zumindest als Teile der Kontaktlöcher) verwendet werden.

Vorteilhafterweise werden unmittelbar an die ersten Vertiefungen angrenzende Bereiche der Oberfläche des ersten Substrats durch die erste Isolationsschicht nicht bedeckt. d.h. die erste Isolationsschicht reicht nicht unmittelbar an den "Rand" der ersten Vertiefungen heran. Auf diese Art und Weise können Abrisskanten erzeugt werden, die in einem späteren Prozessstadium zur getrennten Kontaktierung von leitfähigen Bereichen der Strukturschicht und Oberflächenbereichen des ersten Substrats genutzt werden können.

Vorteilhafterweise werden in der der Strukturschicht zugewandten Seite des ersten und/oder zweiten Substrats vor Aufbringen der Strukturschicht auf den ersten Schichtverbund zweite Vertiefungen erzeugt, deren laterale Positionen wenigstens teilweise den lateralen Positionen der aktiven Struktur bzw. der aktiven Struktur der Strukturschicht entsprechen. Die zweiten Vertiefungen können in einem eigenen Prozessschritt oder zusammen mit den ersten Vertiefungen in einem gemeinsamen Prozessschritt erzeugt werden. Die zweiten Vertiefungen ermöglichen eine mechanische Bewegung (z.B. eine Schwingung) des innerhalb des aktiven Gebiets liegenden Bereichs der Strukturschicht. Weiterhin können die zweiten Vertiefungen zur Einstellung bestimmter Parameter des Bauteils herangezogen werden: Da die mechanische Schwingungsgüte bei bestimmten Bedingungen vor allem von dem in das Bauteil eingeschlossenenen Druck, von der Geometrie der aktiven (beweglichen) Struktur und deren unmittelbarer Umgebung abhängt, ist es beispielsweise möglich, durch die Wahl der Ausmaße der zweiten Vertiefungen die Schwingungsgüte einer schwingungsfähigen aktiven Struktur gezielt zu beeinflussen. So ist die Schwingungsgüte umso größer, je tiefer die zweiten Vertiefungen sind (bei gleichem Druck innerhalb des Bauteils).

In der Strukturschicht können Strukturschichtvertiefungen ausgebildet werden, deren laterale Positionen wenigstens teilweise den lateralen Positionen des aktiven Gebiets bzw. der aktiven Struktur der Strukturschicht entsprechen. Die zweiten Vertiefungen im ersten und zweiten Substrat können in diesem Fall prinzipiell auch weggelassen werden, da eine Bewegung der aktiven Struktur bei entsprechender Ausgestaltung allein in den Strukturschichtvertiefungen erfolgen kann.

Weiterhin können in der ersten und/oder zweiten Isolationsschicht Isolationsschichtvertiefungen ausgebildet werden, deren laterale Positionen wenigstens teilweise den lateralen Positionen des aktiven Gebiets bzw. der aktiven Struktur der Strukturschicht entsprechen. Die zweiten Vertiefungen im ersten und zweiten Substrat sowie die Strukturschichtvertiefungen können in diesem Fall prinzipiell auch weggelassen werden, da eine Bewegung der aktiven Struktur bei entsprechender Ausgestaltung allein in den Isolationsschichtvertiefungen erfolgen kann. Die Isolationsschichtvertiefungen können als Anschlag für einen Teil der aktiven Struktur während deren Bewegung dienen, d.h. die Positionen/Ausgestaltungen der Isolationsschichtvertiefungen können so gewählt werden, dass ein Teil (relativ kleiner Teil) der aktiven (beweglichen) Struktur bei Überschreiten einer bestimmten Auslenkung am Boden der Isolationsschichtvertiefungen anschlägt und damit verhindert, dass der Teil der aktiven Struktur (relativ großer Teil), der eine wesentlich stärkere Auslenkung erfahren kann, da dieser sich innerhalb der zweiten Vertiefungen bewegen kann, mit einer vergleichsweise hohen kinetischen Energie am Boden der zweiten Vertiefungen aufschlägt ("Bruchschutz" der aktiven Struktur ohne Einschränkung der mechanischen Güte der aktiven Struktur). Der als Anschlag dienende Flächenanteil der aktiven Struktur sollte in diesem Fall klein gegenüber dem restlichen Flächenanteil der aktiven Struktur sein.

In dem erfindungsgemäßen Herstellungsverfahren kann natürlich auf alle Arten von Vertiefungen gleichzeitig zurückgegriffen werden, d.h. das durch das erfindungsgemäße Herstellungsverfahren erzeugte Bauteil kann gleichzeitig alle Arten von Vertiefungen aufweisen.

Gewöhnlicherweise stellen das erste und zweite Substrat jeweils einen Teil eines Wafers bzw. Waferverbunds dar, die später vereinzelt werden. Um das Vereinzeln zu erleichtern, können in der der Strukturschicht abgewandten Oberfläche des ersten Substrats und/oder zweiten Substrats dritte Vertiefungen erzeugt werden, die als Sollbruchstellen dienen.

Weiterhin kann es vorteilhaft sein, während des Strukturierprozesses der Strukturschicht Gräben in der Strukturschicht zu erzeugen, die dazu dienen, die aktiven Strukturen von den äußeren Bereichen (Chiprand) der Strukturschicht des herzustellenden Bauteils elektrisch zu isolieren. Damit ist gewährleistet, dass die elektrische Funktion des Bauteils nicht ungewollt gestört wird, selbst wenn die äußeren Enden der Strukturschicht gegenüber ihrer Umgebung nicht elektrisch isoliert sind.

Sind erste Vertiefungen innerhalb des ersten Substrats ausgebildet worden, so kann zum Ausbilden der Kontaktlöcher, ausgehend von der der Strukturschicht abgewandten Oberfläche des ersten Substrats wenigstens ein Teil des ersten Substrats bis zu einer vertikalen Position, die der vertikalen Position der Böden der ersten Vertiefungen entspricht, entfernt werden. Damit werden die ersten Vertiefungen von den Böden der ersten Vertiefungen her kommend "geöffnet" und stehen als Kontaktlöcher zur Verfügung.

Nach Ausbilden der Kontaktlöcher wird in der Regel eine Metallschicht oder eine andere Schicht leitenden Materials auf der der Strukturschicht abgewandten Oberfläche des ersten Substrats abgeschieden. Sind vorher innerhalb des ersten Substrats Abrisskanten erzeugt worden, so kann mittels eines einzigen Abscheideprozesses sowohl eine Schirmelektrode auf der Oberfläche des ersten Substrats zur Abschirmung des Bauteils gegenüber unerwünschter Strahlung als auch eine von der Schirmoberfläche elektrisch isolierte Kontaktschicht (auf den Böden der Kontaktlöcher) zur Kontaktierung der leitfähigen Bereiche der Strukturschicht in einem Schritt erzeugt werden. Der Einsatz von Abrisskanten ermöglicht somit das gleichzeitige Kontaktieren gegeneinander elektrisch zu isolierender Bereiche in einem Prozessschritt.

Das Ausbilden der Kontaktlöcher, der ersten bis dritten Vertiefungen und/oder der Strukturschicht erfolgt vorzugsweise mittels eines Ätzverfahrens. Die Erfindung ist jedoch nicht hierauf beschränkt.

In einer besonders bevorzugten Ausführungsform bestehen sowohl das erste und das zweite Substrat als auch die Strukturschicht aus Silizium. Die Erfindung ist jedoch nicht hierauf beschränkt, auch andere Materialien/Materiallcombinationen sind denkbar. Silizium hat generell die Vorteile guter mechanischer Eigenschaften, hoher Verfügbarkeit und gut entwickelter Bearbeitungsverfahren. Bestehen sämtliche Komponenten aus Silizium, so hat dies folgende Vorteile: geringe thermische Spannung sowie geringe Ausgasung (verglichen zu Pyrex oder SD2 (beide Materialien sind Gläser, die von den Firmen "Hoya" bzw. "Corning Glas" vertrieben werden), womit sich Drücke kleiner 0,01 mbar innerhalb des Bauteils realisieren lassen.

Die Erfindung stellt weiterhin ein Verfahren zum Herstellen eines Bauteils, insbesondere eines mikromechanischen, mikro-elektromechanischen oder mikro-opto-elektromechanischen Bauteils, bereit, das die folgenden Schritte aufweist:
- Aufbringen einer zumindest teilweise leitfähigen Strukturschicht auf ein erstes nichtleitendes Substrat,
- Aufbringen eines zweiten nichtleitenden Substrats auf die Strukturschicht,
- wobei das erste und zweite Substrat sowie die Strukturschicht so ausgestaltet sind, dass zumindest ein Teil der Strukturschicht, der das aktive Gebiet des Bauteils beinhaltet, durch das erste und zweite Substrat hermetisch dicht verschlossen wird,
- Ausbilden von Kontaktlöchern zur Kontaktierung leitfähiger Bereiche der Strukturschicht innerhalb des ersten und/oder zweiten Substrats.

In diesem Verfahren wird die Funktion der Isolationsschichten, die im vorangehenden Verfahren eingesetzt wurden, ersetzt durch die Nichtleitfähigkeit des ersten und zweiten Substrats. Das erste und zweite Substrat besteht hier vorzugsweise aus Quarz, Pyrex oder SD2. Sämtliche im Zusammenhang mit dem vorangehenden Verfahren beschriebenen Ausführungsformen gelten hier analog, soweit anwendbar.

In einer bevorzugten Ausführungsform werden die Kontaktlöcher in dem ersten Substrat ausgebildet und in der der Strukturschicht zugewandten Seite des ersten Substrats vor Aufbringen der Strukturschicht auf das erste Substrat erste Vertiefungen erzeugt, deren laterale Positionen wenigstens teilweise den lateralen Positionen der Kontaktlöcher entsprechen, die später im ersten Substrat ausgebildet werden. Die ersten Vertiefungen weisen eine stufenförmige Form auf, derart, dass die lateralen Ausmaße der oberen Bereiche der ersten Vertiefungen größer sind als die lateralen Ausmaße entsprechender unterer Bereiche. Die stufenförmige Form dient als Abrisskante beim späteren Abscheiden einer leitfähigen Schicht (Schirmelektrode). Der stufenförmige Verlauf der ersten Vertiefungen kann beispielsweise mittels eines zweistufigen Strukturierprozesses erzeugt werden. Die Abrisskanten, die in dem vorangehend beschriebenen Herstellungsverfahren durch die Übergänge zwischen erster Isolationsschicht und den Rändern der ersten Vertiefungen ausgebildet wurden, werden hier also durch die stufenförmigen Verläufe der ersten Vertiefungen ersetzt.

In der folgenden Beschreibung soll eine bevorzugte Ausführungsform des erfindungsgemäßen Herstellungsverfahrens näher erläutert werden. Es wird hierbei ein Herstellungsverfahren eines Bauteils mit vertikalen, galvanisch getrennten Kontaktlöchern, über die eine elektrische Kontaktierung einzelner Elektroden des Bauteils erfolgen kann, beschrieben.

Zunächst wird auf ein geeignetes erstes Substrat, z.B. Silizium, eine fügbare Zwischenschicht aufgebracht (z.B. thermisches Siliziumoxid). Durch ein geeignetes Strukturierungsverfahren (beispielsweise "RIE" (Reactive Ion Etching)) wird diese Zwischenschicht in bestimmten Bereichen entfernt. Das Entfernen der Zwischenschicht erfolgt insbesondere in Bereichen, innerhalb bzw. unterhalb derer sich später freistehende Elemente, die beispielsweise bei Beschleunigungssensoren und Gyroskopen zur Dämpfungsreduzierung in einer Richtung (z-Richtung) zur Anwendung kommen, befinden. Weiterhin wird die Zwischenschicht in Bereichen entfernt, die unmittelbar über den leitfähigen Bereichen zur Kontaktierung der Strukturschicht liegen. In diesen Bereichen sind die lateralen Abmessungen der Zwischenschicht größer als Gruben (erste und zweite Vertiefungen), die in einem weiteren Strukturierungsschritt in das erste Substrat eingebracht werden.

In einem nachfolgenden Fügeprozess (beispielsweise "Silicon Fusion Bonding" (SFB)), dem ein Abdünnen auf eine gewünschte Schichtdicke folgen kann, wird eine Strukturschicht auf das erste Substrat (genauer gesagt auf die darauf aufgebrachte Zwischenschicht) aufgebracht, die nach weiteren Bearbeitungsschritten die aktiven Komponenten des Bauteils enthalten wird. Mittels geeigneter Strukturierungsverfahren (beispielsweise "Deep Reactive Ion Etching" (DRIE)) werden Gruben in der Strukturschicht erzeugt, die bis auf die Zwischenschicht bzw. bis zu den Gruben reichen. Auf diese Art und Weise können Bereiche geschaffen werden, die in lateraler Richtung durch Trenches elektrisch isoliert sind, wobei die minimale Trenchbreite durch technologische Parameter wie Dicke der Strukturschicht und maximales Aspektverhältnis der verwendeten Anlage zur Durchführung des DRIE-Verfahrens bestimmt wird.

Weiterhin werden in einem zweiten Substrat durch geeignete Strukturierungsverfahren, beispielsweise nasschemischem Ätzen oder mittels eines DRIE-Verfahrens Gruben (zweite Vertiefungen) eingebracht. Mittels eines Fügeprozesses wird der Verbund aus erstem Substrat, Zwischenschicht und Strukturschicht justiert mit dem zweiten Substrat verbunden. Die Gruben im zweiten Substrat befinden sich im Bereich der beweglichen bzw. aktiven Strukturen des ersten Verbunds. Auf diese Weise kann sowohl ein mechanischer Schutz bestimmter Elemente der Strukturschicht erreicht werden als auch, falls erforderlich, ein definierter Innendruck eingestellt werden. Die Oberfläche des zweiten Substrats muss, falls das zweite Substrat aus einem leitfähigen bzw. halbleitenden Material besteht, zuvor mit einer fügbaren zweiten Isolationsschicht, beispielsweise thermischem SiO₂ versehen werden, um Kurzschlüsse zwischen den einzelnen elektrisch leitfähigen Bereichen zu verhindern.

Nach dem zweiten Fügeprozess erfolgt eine geeignete Strukturierung des Gesamtverbunds, bestehend aus erstem und zweitem Verbund, wobei die Strukturierung von der Rückseite des ersten Substrats erfolgt, beispielsweise mittels eines DRIE-Verfahrens. Die Tiefe des Strukturierungsprozesses reicht in den Kontaktlochgebieten des ersten Substrats bis zu den Gruben. Dadurch werden die Kontaktlochbereiche von der Rückseite des ersten Substrats für eine nachfolgende Kontaktmetallisierung zugänglich. Gleichzeitig wird ein hermetischer Verschluss des Inneren des Bauteils gewährleistet.

Abschließend wird der Gesamtverbund durch ein geeignetes Metallisierungsverfahren, beispielsweise Sputtern oder Bedampfen, ganzflächig auf der Rückseite des ersten Substrats metallisiert. Hierbei kommt es aufgrund der zurückgesetzten Kanten der isolierenden Zwischenschicht zwischen dem ersten Substrat und der Strukturschicht zu einem Abriss der Metallisierungsschicht. Damit wird eine elektrische Isolation zwischen den einzelnen Elektroden (Kontaktlöchern) und der ganzflächigen Metallisierung auf der Oberfläche des ersten Substrats erreicht.

Auch die Oberfläche des zweiten Substrats kann nach Ausbilden des Gesamtverbunds ganzflächig leitfähig beschichtet werden. In diesem Fall werden beide Substrate als Schirmelektrode genutzt. Die einzelnen galvanisch getrennten Bereiche können durch Drahtbonden kontaktiert werden.

Die Erfindung stellt weiterhin ein mikromechanisches, mikro-elektromechanisches sowie mikro-opto-elektromechanisches Bauteil bereit. Das Bauteil weist auf:
- einen ersten Schichtverbund, der ein erstes Substrat und eine erste Isolationsschicht, die wenigstens einen Teil der Oberfläche des ersten Substrats bedeckt, aufweist,
- einen zweiten Schichtverbund, der ein zweites Substrat und eine zweite Isolationsschicht, die wenigstens einen Teil der Oberfläche des zweiten Substrats bedeckt, aufweist,
- eine zumindest teilweise leitfähige Strukturschicht, die zwischen der ersten Isolationsschicht und der zweiten Isolationsschicht angeordnet ist, wobei der erste und zweite Schichtverbund sowie die Strukturschicht so ausgestaltet sind, dass zumindest ein Teil der Strukturschicht, der das aktive Gebiet des Bauteils beinhaltet, durch den ersten und zweiten Schichtverbund hermetisch dicht verschlossen wird, und
- Kontaktlöcher innerhalb des ersten und/oder zweiten Substrats zur Kontaktierung leitfähiger Bereiche der Strukturschicht.

Die Erfindung stellt weiterhin ein mikromechanisches, mikro-elektromechanisches sowie mikro-opto-elektromechanisches Bauteil bereit. Das Bauteil weist auf:
- ein erstes nichtleitendes Substrat,
- ein zweites nichtleitendes Substrat,
   eine zumindest teilweise leitfähige Strukturschicht, die zwischen dem ersten und dem zweiten Substrat angeordnet ist, wobei das erste und zweite Substrat sowie die Strukturschicht so ausgestaltet sind, dass zumindest ein Teil der Strukturschicht, der das aktive Gebiet des Bauteils beinhaltet, durch das erste und zweite Substrat hermetisch dicht verschlossen wird, und
- Kontaktlöcher zur Kontaktierung leitfähiger Bereiche der Strukturschicht innerhalb des ersten und/oder zweiten Substrats.

Die erfindungsgemäßen Bauteile sind vorzugsweise entsprechend den Bauteil-Varianten, die durch das erfindungsgemäße Bauteil-Herstellungsverfahren herstellbar sind, ausgestaltet.

Die Erfindung wird im Folgenden unter Bezugnahme auf die Figuren in beispielsweiser Ausführungsform näher erläutert. Es zeigen:

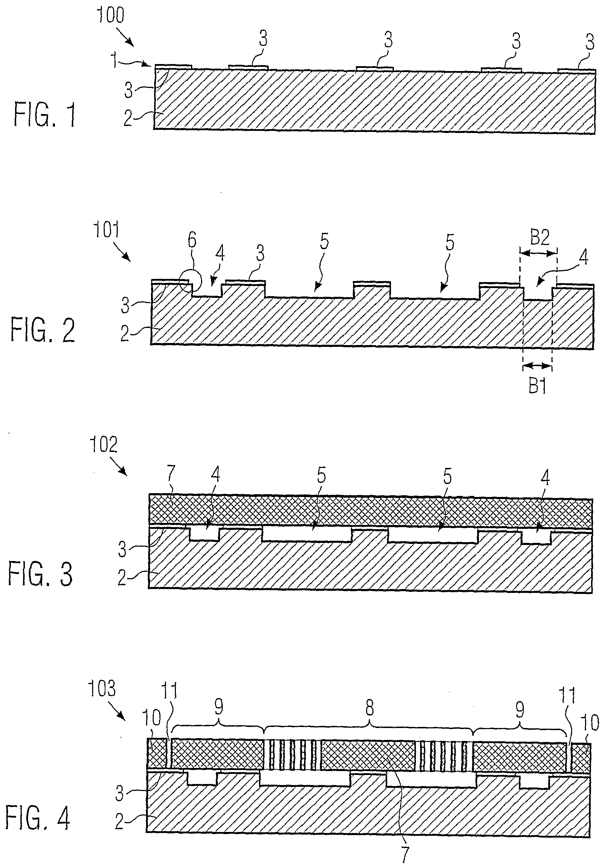

- Fig. 1 - 10: einen ersten bis zehnten Prozessschritt einer bevorzugten Ausführungsform des erfindungsgemäßen Herstellungsverfahrens.

In den Figuren sind identische bzw. einander entsprechende Bereiche, Bauteile sowie Bauteilgruppen mit denselben Bezugsziffern gekennzeichnet.

In der folgenden Beschreibung wird unter Bezugnahme auf die Figuren 1-10 eine bevorzugte Ausführungsform des erfindungsgemäßen Herstellungsverfahrens näher erläutert.

In einem ersten Prozessschritt 100 (Fig. 1) wird auf der Oberfläche 1 eines ersten Substrats 2 eine strukturierte erste Isolationsschicht 3 erzeugt. In einem zweiten Prozessschritt 101 (Fig. 2) werden in der Oberfläche 1 des ersten Substrats 2 erste Vertiefungen 4 sowie zweite Vertiefungen 5 erzeugt. Die Breiten B1 der ersten Vertiefungen 4 fallen hierbei kleiner als die Breiten B2 der Aussparungen der ersten Isolationsschicht 3 oberhalb der ersten Vertiefungen 4 aus. Auf diese Art und Weise entstehen in den an die ersten Vertiefungen 4 angrenzenden Bereichen Abrisskanten 6. Die Breiten der zweiten Vertiefungen 5 entsprechen hingegen den Breiten der oberhalb dieser Vertiefungen 5 liegenden Aussparungen der ersten Isolationsschicht 3.

Auf den so erhaltenen ersten Verbund aus erstem Substrat 2 und erster Isolationsschicht 3 wird in einem dritten Prozessschritt 102 (Fig. 3) eine Strukturschicht 7 aufgebracht, wobei die Strukturschicht 7 auf den einzelnen Bereichen der ersten Isolationsschicht 3 aufliegt.

In einem vierten Prozessschritt 103 (Fig. 4) wird die Strukturschicht 7 so strukturiert, dass eine aktive Struktur 8 entsteht, das mit daran lateral angrenzenden leitfähigen Bereichen 9 der Strukturschicht 7 elektrisch in Verbindung steht, wobei äußere Bereiche 10 (der Chiprand, d.h. der Randbereich des herzustellenden Bauteils) der Strukturschicht 7 durch Gräben 11 von den leitfähigen Bereichen 9 "innerhalb" des Bauteils elektrisch isoliert sind.

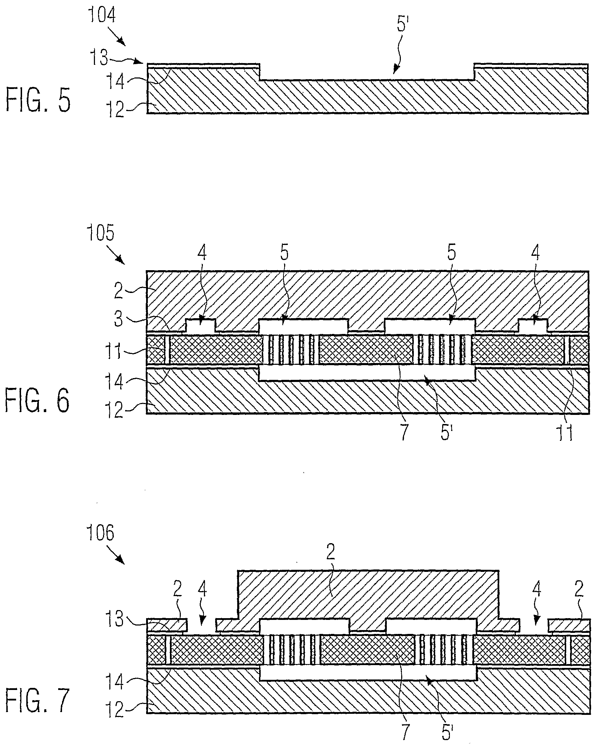

In einem fünften Prozessschritt 104 (Fig. 5) wird ein zweiter Verbund aus einem zweiten Substrat 12 sowie auf der Oberfläche 13 des zweiten Substrats 12 aufgebrachten zweiten Isolationsschicht 14 erzeugt. In der Oberfläche 13 des zweiten Substrats 12 ist eine zweite Vertiefung 5' vorgesehen, deren Breite der Breite der aktiven Struktur 8 entspricht.

In einem sechsten Prozessschritt 105 (Fig. 6) werden der erste Verbund und der zweite Verbund aneinander gefügt, derart, dass die zweite Isolationsschicht 14 an die Strukturschicht 7 angrenzt und die zweiten Vertiefungen 5, 5' oberhalb bzw. unterhalb der aktiven Struktur 8 zu liegen kommen.

In einem siebten Prozessschritt 106 (Fig. 7) wird der äußere Teil des ersten Substrats 2 bis auf eine vertikale Position zurückgeätzt, die der vertikalen Position der Böden der ersten Vertiefungen 4 entspricht, so dass die ersten Vertiefungen 4 freigelegt werden.

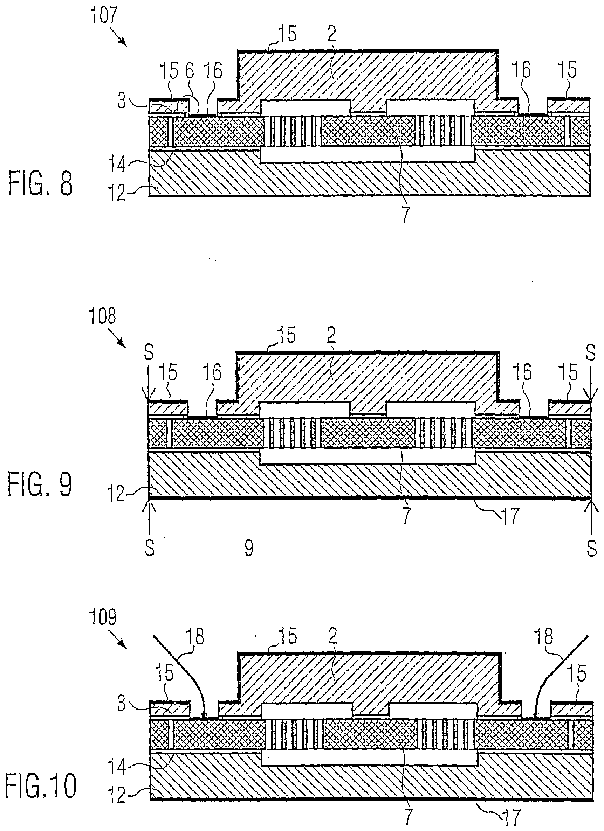

Nun erfolgt in einem achten Prozessschritt 107 (Fig. 8) die Abscheidung einer Metallisierungsschicht 15 auf der Oberfläche des ersten Substrats 2, wobei aufgrund des Vorhandenseins der Abrisskanten 6 der innerhalb der ersten Vertiefungen 4 abgeschiedene Teil der Metallisierungsschicht 15 vom Rest der Metallisierungsschicht elektrisch getrennt wird, so dass innerhalb der ersten Vertiefungen 4 Metall-Kontaktierungsflächen 16 entstehen.

In einem neunten Prozessschritt 108 (Fig. 9) wird auf die der Strukturschicht 7 ab gewandte Oberfläche des zweiten Substrats 12 eine Metallisierungsschicht 17 abgeschieden. Die Metallisierungsschicht 15 sowie die Metallisierungsschicht 17 dienen als Abschirmelektroden zur Abschirmung unerwünschter elektromagnetischer Felder. Die Metallisierungsschicht 15 sowie die Metallisierungsschicht 17 können auf ein definiertes, gemeinsames Potenzial bzw. auf unterschiedliche Potenziale gelegt werden.

Nun erfolgt ein Vereinzelungsprozess, in dem der so entstandene Schichtverbund aus erstem Substrat 2, zweitem Substrat 12 sowie Strukturschicht 7 und Isolationsschichten 3, 14 an Sägekanten S in die einzelnen Bauteile vereinzelt wird (in den Figuren ist nur ein Ausschnitt des Verbunds mit einem Bauteil zu sehen).

In einem zehnten Prozessschritt 109 (Fig. 10) werden die Kontaktflächen 16 durch Bonddrähte 18 kontaktiert.

Bestehen erstes und zweites Substrat 2, 12 aus nichtleitenden Materialien, so können die Isolationsschichten 3, 14 weggelassen werden.

Erfindungsgemäß wurde demnach ein Verfahren zur Herstellung mikroelektromechanischer bzw. mikro-opto-elektromechanischer Bauelemente, insbesondere Bauelemente mit hermetisch dicht verkapselten aktiven Strukturen und Flächen zur elektrischen Kontaktierung derselben beschrieben. Das erfindungsgemäße Herstellungsverfahren ermöglicht eine hermetisch dichte Verkapselung bestimmter Bereiche der Strukturschicht auf Waferebene mit einem nahezu beliebig einstellbaren Innendruck und bietet die Möglichkeit, eine von den anderen elektrischen Kontakten elektrisch isolierte Schirmung zum Schutz gegen äußere elektromagnetische Störfelder zu erzeugen.

Das erfindungsgemäße Herstellungsverfahren benutzt ein erstes Substrat, in das durch ein geeignetes Verfahren Gruben eingebracht werden, und das durch eine um die Gruben herum zurückgesetzte, fügbare, elektrisch isolierende Zwischenschicht bedeckt ist. Durch ein geeignetes Fügeverfahren wird auf das erste Substrat eine strukturierte bzw. strukturierbare Strukturschicht aufgebracht, die Gruben aufweist, die entweder bis zu den Gruben des ersten Substrats bzw. bis zu der Zwischenschicht reichen. Weiterhin wird ein zweites Substrat erzeugt, das ebenfalls eine mit Gruben strukturierte Oberfläche, die wiederum mit der Strukturschicht des ersten Substrats gefügt wird, aufweist. Die der Zwischenschicht des ersten Substrats abgewandte Oberfläche wird derart strukturiert, dass Gruben entstehen, die bis zu den Gruben der gegenüberliegenden Seite des ersten Substrats reichen. Durch ein geeignetes Verfahren wird auf die der Zwischenschicht abgewandten Oberfläche des ersten Substrats ganzflächig eine elektrisch leitfähige Schicht aufgebracht, wobei die zurückgesetzten Kanten der elektrisch isolierbaren, fügbaren Zwischenschicht auf dem ersten Substrat als Abrisskante dienen können, wodurch zusammen mit den Gruben in der Strukturschicht des ersten Substrats Anschlüsse für elektrisch isolierte Bereiche in der Strukturschicht entstehen. Durch das Strukturierungsverfahren der der Zwischenschicht des ersten Substrats abgewandten Oberfläche werden gleichzeitig Gruben erzeugt, die als Sollbruchstellen für einen Vereinzelungsprozess dienen können.

Zur Isolierung des leitfähigen Materials des ersten Substrats werden vorteilhafterweise Abrisskanten eingesetzt, über die eine galvanische Trennung der elektrisch leitenden Seitenwände des Kontaktlochs gegenüber dem Kontaktlochboden, der (oftmals direkt) mit einer Elektrode des Bauelements verbunden ist, bewirkt wird.

Wie aus der vorangehenden Beschreibung deutlich geworden ist, weist das erfindungsgemäße Herstellungsverfahren folgende Vorteile auf:
Die Kontaktlöcher werden von der Rückseite des ersten Substrats her geöffnet, auf dem die Strukturschicht mit einem Fügeprozess aufgebracht wurde. Der Fügeprozess ist unkritisch bezüglich Fügetoleranzen, wenn das "Ausrichten" der Strukturschicht nicht mittels des Fügeprozesses, sondern mittels einer Doppelseitenlithografie erfolgt, deren Toleranzen wesentlich geringer sind als die des Fügeprozesses. Wird die Strukturschicht vor Aufbringen auf dem Substrat strukturiert, so entfällt dieser Vorteil.

Die Metallisierung der Kontaktbereiche wird erst nach Abschluss sämtlicher Fügeprozesse durchgeführt. Somit können Verfahren wie beispielsweise Silizium-Direkt-Bonden (SFB) mit Temperaturbelastungen größer als 400°C eingesetzt werden, sofern keine dotierten aktiven Gebiete innerhalb der Strukturschicht existieren, deren Dotierungsprofile bei höheren Temperaturen beeinträchtigt werden könnten.

Die Öffnung der Kontaktlöcher erfolgt erst nach dem Fügeprozess zum hermetisch dichten Verschließen. Dadurch kann die Fügefläche vergrößert und somit der Fügeprozess vereinfacht werden. Unter "Fügeflächen" werden die Fläche verstanden, die während des Fügeprozesses miteinander in Kontakt gebracht werden. Je größer die Fügeflächen sind, umso größer sind die Kräfte, die die Fügepartner (Substrat, Wafer, etc.) zusammenhalten.

Die Erfindung lässt sich auf den Herstellungsprozess beliebiger (miniaturisierter) Bauteile anwenden, insbesondere auf den Herstellungsprozess eines mikromechanischen, mikro-elektromechanischen oder mikro-opto-elektromechanischen Bauteils, wie Beschleunigungssensoren, Drehratensensoren, Drucksensoren, optische Kopplungen, etc..

### Referenzen

1. Daniel Lapadatu et al., "Dual-Axes Capacitive Inclinometer / Low-g Accelerometer for Automotive Application", MEMS 2001, pp. 34-37, 2001
2. Th. Diepold, E. Obermeier, "Bulk MIcromachining of Borosilicat Glas by Ultrasonic Drilling and Sandblasting", Microsystems Technologies 96, pp. 211-216, 1996
3. U. Breng et al., "µCORS - A Bulk Micromachined Gyroscope Based on Coupled Resonators", Transducers '99, pp. 1570-1573, 1999
4. A. Gaißer et al., "Digital Readout Electronics for MIcro-Machined Gyroscopes with Enhanced Sensor Design", Symposium Gyro Technology 2002, pp. 5.0-5.11, 2002
5. T. Gessner et al., "Mikromechanische Beschleunigungsmessvorrichtung und Verfahren zu deren Herstellung", EP 000000623824 A1

## Patentansprüche

1. Verfahren zum Herstellen eines Bauteils, insbesondere eines mikromechanischen, mikro-elektromechanischen oder mikro-opto-elektromechanischen Bauteils, mit den folgenden Schritten:
- Erzeugen eines ersten Schichtverbunds, der ein erstes Substrat (2) und eine erste Isolationsschicht (3), die wenigstens einen Teil der Oberfläche (1) des ersten Substrats (2) bedeckt, aufweist,
- Erzeugen eines zweiten Schichtverbunds, der ein zweites Substrat (12) und eine zweite Isolationsschicht (14), die wenigstens einen Teil der Oberfläche (13) des zweiten Substrats (12) bedeckt, aufweist,
- Aufbringen einer zumindest teilweise leitfähigen Strukturschicht (7) auf die erste Isolationsschicht (3),
- Aufbringen des zweiten Verbunds auf die Strukturschicht (7), derart, dass die zweite Isolationsschicht (14) an die Strukturschicht (7) angrenzt,
- wobei der erste und zweite Schichtverbund sowie die Strukturschicht (7) so ausgestaltet sind, dass zumindest ein Teil der Strukturschicht (7), der das aktive Gebiet (8) des Bauteils beinhaltet, durch den ersten und zweiten Schichtverbund hermetisch dicht verschlossen wird,
- nach Aufbringen des zweiten Verbunds auf die Strukturschicht (7) Ausbilden von Kontaktlöchern (4) in dem ersten Substrat (2) zur Kontaktierung leitfähiger Bereiche (9) der Strukturschicht (7) , wobei
in der der Strukturschicht (7) zugewandten Seite des ersten Substrats (2) vor Aufbringen der Strukturschicht (7) auf den ersten Schichtverbund erste Vertiefungen (4) erzeugt werden, deren laterale Positionen wenigstens teilweise den lateralen Positionen der Kontaktlöcher entsprechen, die später im ersten Substrat (2) ausgebildet werden.

2. Verfahren nach Anspruch 1, **dadurch gekennzeichnet, dass** die aktive Struktur (8) durch Strukturieren der Strukturschicht (7) erzeugt wird, wobei das Strukturieren vor oder nach Aufbringen der Strukturschicht (7) auf den ersten Schichtverbund erfolgt.

3. Verfahren nach Anspruch 1 oder 2, **dadurch gekennzeichnet, dass** unmittelbar an die ersten Vertiefungen (4) angrenzende Bereiche der Oberfläche (1) des ersten Substrats (2) durch die erste Isolationsschicht (3) nicht bedeckt werden.

4. Verfahren nach einem der Ansprüche 1 bis 3, **dadurch gekennzeichnet, dass** in der der Strukturierschicht (7) zugewandten Seite des ersten und/oder zweiten Substrats (2, 12) vor Aufbringen der Strukturschicht (7) auf den ersten Schichtverbund zweite Vertiefungen (5, 5') erzeugt werden, deren laterale Positionen wenigstens teilweise den lateralen Positionen der aktiven Struktur (8) der Strukturschicht (7) entsprechen.

5. Verfahren nach einem der Ansprüche 1 bis 4, **dadurch gekennzeichnet, dass** in der der Strukturschicht (7) abgewandten Oberfläche des ersten Substrats dritte Vertiefungen erzeugt werden, die als Sollbruchstellen dienen.

6. Verfahren nach einem der Ansprüche 2 bis 5, **dadurch gekennzeichnet, dass** beim Strukturieren der Strukturschicht (7) Gräben (11) in der Strukturschicht erzeugt werden, die die aktive Struktur (8) von den äußeren Bereichen (10) der Strukturschicht (7) elektrisch isolieren.

7. Verfahren nach einem der Ansprüche 1 bis 6, **dadurch gekennzeichnet, dass** zum Ausbilden der Kontaktlöcher (4), ausgehend von der der Strukturschicht (7) abgewandten Oberfläche des ersten Substrats (2), wenigstens ein Teil des ersten Substrats bis zu einer vertikalen Position, die der vertikalen Position der Böden der ersten Vertiefungen (4) entspricht, entfernt wird.

8. Verfahren nach einem der Ansprüche 1 bis 6, **dadurch gekennzeichnet, dass** nach Ausbilden der Kontaktlöcher (4) eine Metallschicht (15) auf der der Strukturschicht (7) abgewandten Oberfläche des ersten Substrats (2) abgeschieden wird.

9. Verfahren nach einem der Ansprüche 1 bis 8, **dadurch gekennzeichnet, dass** das Ausbilden der Kontaklöcher, der ersten bis dritten Vertiefungen (4, 5, 5'), und/oder der Strukturschicht (7) mittels eines Ätzverfahrens erfolgt.

10. Verfahren nach einem der Ansprüche 1 bis 9, **dadurch gekennzeichnet, dass** das erste Substrat (2), das zweite Substrat (12) sowie die Strukturschicht (7) aus demselben Halbleitermaterial, insbesondere Silizium, bestehen.

11. Verfahren nach einem der Ansprüche 1 bis 10, **dadurch gekennzeichnet, dass** in der Strukturschicht Strukturschichtvertiefungen ausgebildet werden, deren laterale Positionen wenigstens teilweise den lateralen Positionen der aktiven Struktur (8) der Strukturschicht (7) entsprechen.

12. Verfahren nach einem der Ansprüche 1 bis 11, **dadurch gekennzeichnet, dass** in der ersten und/oder zweiten Isolationsschicht Isolationsschichtvertiefungen ausgebildet werden, deren laterale Positionen wenigstens teilweise den lateralen Positionen der aktiven Struktur (8) der Strukturschicht (7) entsprechen.

13. Verfahren nach Anspruch 12, **dadurch gekennzeichnet, dass** die Isolationsschichtvertiefungen als Anschlag für einen Teil der aktiven Struktur während deren Bewegung dienen.

14. Verfahren zum Herstellen eines Bauteils, insbesondere eines mikromechanischen, mikro-elektromechanischen oder mikro-opto-elektromechanischen Bauteils, mit den folgenden Schritten:
- Aufbringen einer zumindest teilweise leitfähigen Strukturschicht (7) auf ein erstes nichtleitendes Substrat (2),
- Aufbringen eines zweiten nichtleitenden Substrats (12) auf die Strukturschicht (7),
- wobei das erste und zweite Substrat (2, 12) sowie die Strukturschicht (7) so ausgestaltet sind, dass zumindest ein Teil der Strukturschicht (7), der das aktive Gebiet (8) des Bauteils beinhaltet, durch das erste und zweite Substrat hermetisch dicht verschlossen wird,
- nach Aufbringen des zweiten nichtleitenden Substrats (12) auf die Strukturschicht (7) Ausbilden von Kontaktlöchern (4) in dem ersten Substrat (2) zur Kontaktierung leitfähiger Bereiche (9) der Strukturschicht (7) wobei
in der der Strukturschicht (7) zugewandten Seite des ersten Substrats (2) vor Aufbringen der Strukturschicht (7) auf das erste Substrat erste Vertiefungen (4) erzeugt werden, deren laterale Positionen wenigstens teilweise den lateralen Positionen der Kontaktlöcher entsprechen, die später im ersten Substrat (2) ausgebildet werden.

15. Verfahren nach Anspruch 14, **dadurch gekennzeichnet, dass** das erste und zweite Substrat aus Quarz, Pyrex oder SD2 bestehen oder diese Materialien aufweisen.

16. Verfahren nach einem der Ansprüche 14 oder 15, **dadurch gekennzeichnet, dass** die ersten Vertiefungen (4) eine stufenförmige Form aufweisen, derart, dass die lateralen Ausmaße der oberen Bereiche der ersten Vertiefungen größer sind als die lateralen Ausmaße entsprechender unterer Bereiche.

17. Verfahren nach Anspruch 16, **dadurch gekennzeichnet, dass** der stufenförmige Verlauf der ersten Vertiefungen (4) mittels eines zweistufigen Strukturierprozesses erzeugt wird.

## Claims

1. A method for fabricating a component, in particular a micromechanical, microelectromechanical or microoptoelectromechanical component, comprising the following steps:
- producing a first layer composite having a first substrate (2) and a first insulation layer (3), which covers at least one part of the surface (1) of the first substrate (2),
- producing a second layer composite having a second substrate (12) and a second insulation layer (14), which covers at least one part of the surface (13) of the second substrate (12),
- applying an at least partly conductive structure layer (7) to the first insulation layer (3),
- applying the second composite to the structure layer (7) in such a way that the second insulation layer (14) adjoins the structure layer (7),
- wherein the first and second layer composites and also the structure layer (7) are configured in such a way that at least one part of the structure layer (7) which comprises the active area (8) of the component is hermetically tightly sealed by the first and second layer composites,
- after applying the second composite to the structure layer (7), forming contact holes (4) in the first substrate (2) for making contact with conductive regions (9) of the structure layer (7), wherein
first depressions (4) are produced in that side of the first substrate (2) which faces the structure layer (7) before the structure layer (7) is applied to the first layer composite, the lateral positions of said first depressions at least partly corresponding to the lateral positions of the contact holes which are formed later in the first substrate (2).

2. The method as claimed in claim 1, **characterized in that** the active structure (8) is produced by patterning the structure layer (7), wherein the patterning is effected before or after the structure layer (7) is applied to the first layer composite.

3. The method as claimed in either of claims 1 and 2, **characterized in that** regions of the surface (1) of the first substrate (2) which directly adjoin the first depressions (4) are not covered by the first insulation layer (3).

4. The method as claimed in one of claims 1 to 3, **characterized in that** second depressions (5, 5') are produced **in that** side of the first and/or second substrate (2, 12) which faces the structure layer (7) before the structure layer (7) is applied to the first layer composite, the lateral positions of said second depressions at least partly corresponding to the lateral positions of the active structure (8) of the structure layer (7).

5. The method as claimed in one of claims 1 to 4, **characterized in that** third depressions are produced **in that** surface of the first substrate which is remote from the structure layer (7), said third depressions serving as desired breaking points.

6. The method as claimed in one of claims 2 to 5, **characterized in that** trenches (11) are produced in the structure layer during the patterning of the structure layer (7), said trenches electrically insulating the active structure (8) from the outer regions (10) of the structure layer (7).

7. The method as claimed in one of claims 1 to 6, **characterized in that**, for forming the contact holes (4), proceeding from that surface of the first substrate (2) which is remote from the structure layer (7), at least one part of the first substrate is removed as far as a vertical position corresponding to the vertical position of the bottoms of the first depressions (4).

8. The method as claimed in one of claims 1 to 6, **characterized in that** after the contact holes (4) have been formed, a metal layer (15) is deposited on that surface of the first substrate (2) which is remote from the structure layer (7).

9. The method as claimed in one of claims 1 to 8, **characterized in that** the contact holes, the first to third depressions (4, 5, 5') and/or the structure layer (7) are formed by means of an etching method.

10. The method as claimed in one of claims 1 to 9, **characterized in that** the first substrate (2), the second substrate (12) and also the structure layer (7) are composed of the same semiconductor material, in particular silicon.

11. The method as claimed in one of claims 1 to 10, **characterized in that** structure layer depressions are formed in the structure layer, the lateral positions of said structure layer depressions at least partly corresponding to the lateral positions of the active structure (8) of the structure layer (7).

12. The method as claimed in one of claims 1 to 11, **characterized in that** insulation layer depressions are formed in the first and/or second insulation layer, the lateral positions of said insulation layer depressions at least partly corresponding to the lateral positions of the active structure (8) of the structure layer (7).

13. The method as claimed in claim 12, **characterized in that** the insulation layer depressions serve as a stop for a part of the active structure during the movement thereof.

14. A method for fabricating a component, in particular a micromechanical, microelectromechanical or microoptoelectromechanical component, comprising the following steps:
- applying an at least partly conductive structure layer (7) to a first nonconductive substrate (2),
- applying a second nonconductive substrate (12) to the structure layer (7),
- wherein the first and second substrates (2, 12) and also the structure layer (7) are configured in such a way that at least one part of the structure layer (7) which comprises the active area (8) of the component is hermetically tightly sealed by the first and second substrates,
- after applying the second composite to the structure layer (7), forming contact holes (4) in the first substrate (2) for making contact with conductive regions (9) of the structure layer (7), wherein
first depressions (4) are produced in that side of the first substrate (2) which faces the structure layer (7) before the structure layer (7) is applied to the first structure, the lateral positions of said first depressions at least partly corresponding to the lateral positions of the contact holes which are formed later in the first substrate (2).

15. The method as claimed in claim 14, **characterized in that** the first and second substrates are composed of quartz, Pyrex or SD2 or comprise these materials.

16. The method as claimed in either of claims 14 and 15, **characterized in that** the first depressions (4) are having a stepped form in such a way that the lateral dimensions of the upper regions of the first depressions are larger than the lateral dimensions of corresponding lower regions.

17. The method as claimed in claim 16, **characterized in that** the stepped course of the first depressions (4) is produced by means of a two-stage patterning process.

## Revendications

1. Procédé pour fabriquer un composant, en particulier un composant micromécanique, micro-électromécanique ou micro-opto-électromécanique, avec les étapes suivantes :
- production d'un premier composite en couches, qui comporte un premier substrat (2) et une première couche isolante (3) couvrant une partie au moins de la surface (1) du premier substrat (2),
- production d'un deuxième composite en couches, qui comporte un deuxième substrat (12) et une deuxième couche isolante (14) couvrant une partie au moins de la surface (13) du deuxième substrat (12),
- application d'une couche de structure (7), au moins en partie conductrice, sur la première couche isolante (3),
- application du deuxième composite sur la couche de structure (7) de telle sorte que la deuxième couche isolante (14) soit voisine de la couche de structure (7),
- les premier et deuxième composites en couches ainsi que la couche de structure (7) étant conçus pour qu'une partie au moins de la couche de structure (7) qui contient la zone active (8) du composant soit fermée hermétiquement par les premier et deuxième composites en couches,
- après l'application du deuxième composite sur la couche de structure (7), formation de trous de contact (4) dans le premier substrat (2) en vue de la connexion de zones conductrices (9) de la couche de structure (7),
des premiers creux (4) étant réalisés, avant l'application de ladite couche de structure (7) sur le premier composite, dans le côté du premier substrat (2) tourné vers la couche de structure (7), la position latérale desdits creux (4) correspondant au moins en partie à la position latérale des trous de contact qui seront formés plus tard dans le premier substrat (2).

2. Procédé selon la revendication 1, **caractérisé en ce que** la structure active (8) est produite grâce à la structuration de la couche de structure (7), ladite structuration se faisant avant ou après l'application de la couche de structure (7) sur le premier composite en couches.

3. Procédé selon la revendication 1 ou 2, **caractérisé en ce que** les zones de la surface (1) du premier substrat (2) qui sont directement voisines des premiers creux (4) ne sont pas couvertes par la première couche isolante (3).

4. Procédé selon l'une des revendications 1 à 3, **caractérisé en ce que** des deuxièmes creux (5, 5') sont réalisés, avant l'application de la couche de structure (7) sur le premier composite, dans le côté des premier et/ou deuxième substrats (2, 12) tourné vers ladite couche de structure (7), la position latérale desdits creux (5) correspondant au moins en partie aux positions latérales de la structure active (8) de la couche de structure (7).

5. Procédé selon l'une des revendications 1 à 4, **caractérisé en ce que** dans la surface du premier substrat opposée à la couche de structure (7) sont réalisés des troisièmes creux, qui servent de points de rupture.

6. Procédé selon l'une des revendications 2 à 5, **caractérisé en ce que** lors de la structuration de la couche de structure (7) sont réalisées dans celle-ci des tranchées (11) qui isolent électriquement la structure (8) par rapport aux zones extérieures (10) de la couche de structure (7).

7. Procédé selon l'une des revendications 1 à 6, **caractérisé en ce que** pour former les trous de contact (4), à partir de la surface du premier substrat (2) opposée à la couche de structure (7), une partie au moins du premier substrat est enlevée jusqu'à une position verticale qui correspond à la position verticale des fonds des premiers creux (4).

8. Procédé selon l'une des revendications 1 à 6, **caractérisé en ce qu'**après la formation des trous de contact (4), une couche de métal (15) est déposée sur la surface du premier substrat (2) opposée à la couche de structure (7).

9. Procédé selon l'une des revendications 1 à 8, **caractérisé en ce que** la formation des trous de contact, des premiers à troisièmes creux (4, 5, 5') et/ou de la couche de structure (7) se fait à l'aide d'un procédé de gravure.

10. Procédé selon l'une des revendications 1 à 9, **caractérisé en ce que** le premier substrat (2), le deuxième substrat (12) et la couche de structure (7) se composent du même matériau semi-conducteur, en particulier de silicium.

11. Procédé selon l'une des revendications 1 à 10, **caractérisé en ce que** dans la couche de structure sont formés des creux de couche de structure dont les positions latérales correspondent en partie aux positions latérales de la structure active (8) de la couche de structure (7).

12. Procédé selon l'une des revendications 1 à 11, **caractérisé en ce que** dans les première et/ou deuxième couches isolantes sont formés des creux de couche isolante dont les positions latérales correspondent en partie aux positions latérales de la structure active (8) de la couche de structure (7).

13. Procédé selon la revendication 12, **caractérisé en ce que** les creux de couche isolante servent de butée pour une partie de la structure active pendant le déplacement de celle-ci.

14. Procédé pour fabriquer un composant, en particulier un composant micromécanique, micro-électromécanique ou micro-opto-électromécanique, avec les étapes suivantes :
- application d'une couche de structure (7), au moins en partie conductrice, sur un premier substrat non conducteur (2),
- application d'un deuxième substrat non conducteur (12) sur la couche de structure (7),
- les premier et deuxième substrats (2, 12) ainsi que la couche de structure (7) étant conçus pour qu'une partie au moins de la couche de structure (7) qui contient la zone active (8) du composant soit fermée hermétiquement par les premier et deuxième substrats,
- après l'application du deuxième substrat non conducteur (12) sur la couche de structure (7), formation de trous de contact (4) dans le premier substrat (2) en vue de la connexion de zones conductrices (9) de la couche de structure (7),
des premiers creux (4) étant réalisés, avant l'application de ladite couche de structure (7) sur le premier substrat, dans le côté du premier substrat (2) tourné vers la couche de structure (7), la position latérale desdits creux (4) correspondant au moins en partie à la position latérale des trous de contact qui seront formés plus tard dans le premier substrat (2).

15. Procédé selon la revendication 14, **caractérisé en ce que** les premier et deuxième substrats se composent de quartz, de Pyrex ou de SD2 ou comportent ces matériaux.

16. Procédé selon l'une des revendications 14 ou 15, **caractérisé en ce que** les premiers creux (4) présentent une forme étagée, de telle sorte que les dimensions latérales de leurs zones supérieures sont plus grandes que les dimensions latérales des zones inférieures correspondantes.

17. Procédé selon la revendication 16, **caractérisé en ce que** la forme étagée des premiers creux (4) est produite à l'aide d'un processus de structuration à deux étages.
